# EUROPÄISCHE PATENTSCHRIFT

(11) **EP 3 521 837 B1**
(45) Veröffentlichungstag und Bekanntmachung des Hinweises auf die Patenterteilung: **16.11.2022**
(21) Anmeldenummer: 19154527.6
(22) Anmeldetag: 30.01.2019
(51) Int. Cl.: G01R 22/06

(54) **ELEKTRIZITÄTSZÄHLER MIT EINER OPTISCHEN KOMMUNIKATIONSSCHNITTSTELLE**
ELECTRICITY METER WITH AN OPTICAL COMMUNICATION INTERFACE
COMPTEUR D'ÉLECTRICITÉ DOTÉ D'UNE INTERFACE DE COMMUNICATION OPTIQUE

(30) Priorität: 31.01.2018 DE 102018102168
(43) Veröffentlichungstag der Anmeldung: 07.08.2019
(73) Patentinhaber: EMH metering GmbH & Co. KG, 19258 Gallin (DE)
(72) Erfinder: Kramer, Jochen, 21376 Eyendorf (DE)
(74) Vertreter: Hauck Patentanwaltspartnerschaft mbB

(56) Entgegenhaltungen:
- DE-A1-102013 111 483
- US-A- 5 066 906
- US-B1- 6 739 886

## Beschreibung

Die Erfindung betrifft einen Elektrizitätszähler mit einer optischen Kommunikationsschnittstelle. Die optische Kommunikationsschnittstelle ist zur Übertragung von Verbrauchsdaten bestimmt, sodass die von dem Elektrizitätszähler erfassten Verbrauchsdaten einfacher als durch manuelles Ablesen zur Verfügung gestellt werden können.

Aus dem "Lastenheft eHZ - Elektronische Haushaltszähler", Version 2.1, herausgegeben vom FNN Forum Netztechnik/Netzbetrieb im VDE, ist ein Elektrizitätszähler bekannt geworden, der eine frontseitige optische Kommunikationsschnittstelle (als "INFO-Schnittstelle" bezeichnet) und eine rückwärtige optische Kommunikationsschnittstelle (als "MSB-Schnittstelle" bezeichnet) aufweist. Soweit jetzt und im Folgenden von unten, oben, vorn, hinten, Frontseite oder Rückseite die Rede ist, beziehen sich diese Angaben stets auf die übliche Einbauposition des Elektrizitätszählers beispielsweise in einem Zählerschrank, bei der die Frontseite einem Benutzer zugewandt ist.

Die frontseitige optische Kommunikationsschnittstelle ist zur vorübergehenden Verbindung mit einem optischen Kommunikationskopf gemäß EN 62056-21:2002 bestimmt. Derartige optische Kommunikationsköpfe werden beispielsweise von einem Servicetechniker kurzzeitig an die Vorderseite des Elektrizitätszählers angesetzt, um eine Kommunikation über die optische Kommunikationsschnittstelle zu ermöglichen. Sie können mit einem integrierten Magneten am Elektrizitätszähler gehalten werden.

Die rückwärtige optische Kommunikationsschnittstelle ist zur dauerhaften Verbindung mit einem optischen Kommunikationskopf gemäß "Lastenheft - Optischer Kommunikationskopf (OKK) für BKE-Montage", Version 1.0, ebenfalls herausgegeben vom FNN bestimmt. Hierzu wird der optische Kommunikationskopf in eine komplementär geformte Aufnahme einer Befestigungs- und Kontaktiereinheit (BKE) eingesetzt, bevor der Elektrizitätszähler an der BKE befestigt wird. Nach der Befestigung des Elektrizitätszählers wird dieser auf der BKE plombiert, sodass die rückwärtige optische Kommunikationsschnittstelle nicht mehr zugänglich ist. Der in die BKE eingesetzte optische Kommunikationskopf ist durch die Plombierung des Elektrizitätszählers auf der BKE ebenfalls vor unbefugtem Zugriff geschützt.

Aus dem US-Patent Nr. 5,066,906 ist ein Elektrizitätszähler mit einer optischen Kommunikationsschnittstelle bekannt geworden.

Aus der Druckschrift DE 10 2013 111 483 A1 ist ein Elektrizitätszähler mit den Merkmalen des Oberbegriffs des Anspruchs 1 bekannt geworden.

Davon ausgehend ist die Aufgabe der Erfindung, einen Elektrizitätszähler mit einer kostengünstigen, universell einsetzbaren optischen Kommunikationsschnittstelle zur Verfügung zu stellen.

Diese Aufgabe wird gelöst durch den Elektrizitätszähler mit den Merkmalen des Anspruchs 1 und durch das System mit einem Elektrizitätszähler und einer optischen Kommunikationsschnittstelle mit den Merkmalen des Anspruchs 10. Vorteilhafte Ausgestaltungen sind in den Unteransprüchen angegeben.

Der Elektrizitätszähler hat einen plombierbaren Deckel und eine optische Kommunikationsschnittstelle, die an einer Vorderseite des Elektrizitätszählers angeordnet und bei geschlossenem und plombiertem Deckel zugänglich ist, sowie eine Aufnahme zum Einsetzen eines optischen Kommunikationskopfs, die so an der optischen Kommunikationsschnittstelle angeordnet ist, dass sie von dem geschlossenen Deckel teilweise abgedeckt wird.

Die Aufnahme kann eine Tiefe aufweisen, zum Beispiel im Bereich von 4 mm bis 20 mm, insbesondere im Bereich von 12 mm bis 15 mm.

Der plombierbare Deckel ist dazu bestimmt, den Elektrizitätszähler bzw. Teile davon vor unbefugtem Zugriff zu schützen. Die optische Kommunikationsschnittstelle ist an einer Vorderseite des Elektrizitätszählers angeordnet und bei geschlossenem und plombiertem Deckel zugänglich. Es besteht also beispielsweise für einen Servicetechniker ungehinderter Zugang zu der optischen Kommunikationsschnittstelle während des Betriebs des Elektrizitätszählers. Hierfür muss weder der Deckel geöffnet noch der Elektrizitätszähler aus seiner Einbauposition, beispielsweise in einem Zählerschrank, entfernt werden. Alternativ besteht bei der Erfindung die Möglichkeit, einen optischen Kommunikationskopf in die Aufnahme der optischen Kommunikationsschnittstelle einzusetzen. Hierzu muss der Deckel geöffnet werden. Nach dem Schließen des Deckels und dessen Plombierung deckt der Deckel die Aufnahme, in der sich der optische Kommunikationskopf befindet, teilweise ab, sodass der optische Kommunikationskopf bei geschlossenem Deckel nicht ohne weiteres aus der Aufnahme entfernt werden kann. Insbesondere kann dieser optische Kommunikationskopf dauerhaft am Elektrizitätszähler verbleiben und beispielsweise in Verbindung mit einem Smart Meter Gateway für eine kontinuierliche Fernauslesung des Elektrizitätszählers genutzt werden.

Die Erfindung beruht auf der Erkenntnis, dass die gemäß Lastenheft eHZ ausgestalteten Elektrizitätszähler nur für bestimmte Anwendungssituationen sinnvoll sind. Dies gilt insbesondere, wenn gleich bei der Erstinstallation des Elektrizitätszählers eine Fernauslesung über die rückwärtige optische Kommunikationsschnittstelle eingerichtet wird. In diesem Fall kann der in die BKE eingesetzte optische Kommunikationskopf vor der Montage des Elektrizitätszählers einfach installiert werden. Anschließend steht die frontseitige optische Kommunikationsschnittstelle zusätzlich zur Verfügung.

Eine Nachrüstung eines bereits installierten Elektrizitätszählers mit einem optischen Kommunikationskopf für die rückwärtige optische Kommunikationsschnittstelle ist jedoch sehr aufwendig, da hierfür der Elektrizitätszähler komplett deinstalliert werden muss. Außerdem wird die zusätzlich vorgesehene, frontseitige optische Kommunikationsschnittstelle nur selten genutzt, wenn bereits eine Fernauslesung über die rückwärtige optische Kommunikationsschnittstelle erfolgt. Die zusätzlichen Kosten für die frontseitige optische Kommunikationsschnittstelle erscheinen daher in derjenigen Anwendungssituation, in der der bekannte Elektrizitätszähler grundsätzlich gut geeignet ist, daher kaum gerechtfertigt.

Der Elektrizitätszähler der Erfindung vermeidet die genannten Nachteile, indem er lediglich eine einzige optische Kommunikationsschnittstelle zur Verfügung stellt. Sie befindet sich an einer Vorderseite des Elektrizitätszählers, sodass sie im Betrieb des Elektrizitätszählers zugänglich ist, ohne den Elektrizitätszähler deinstallieren zu müssen. Sie kann entweder für einen nur kurzzeitig anzusetzenden optischen Kommunikationskopf genutzt werden, oder für einen in die Aufnahme eingesetzten, dauerhaft installierten und entsprechend gesicherten optischen Kommunikationskopf. Im letztgenannten Fall steht die optische Kommunikationsschnittstelle nicht gleichzeitig für einen weiteren, kurzzeitig anzusetzenden optischen Kommunikationskopf zur Verfügung, was jedoch aus den genannten Gründen kein praxisrelevanter Nachteil ist.

Die optische Kommunikationsschnittstelle weist eine Sende- und Empfangseinrichtung für Lichtsignale auf, die eine vorgegebene Anordnung einhält. Damit ein optischer Kommunikationskopf mit im Wesentlichen komplementär angeordneter Sende- und Empfangseinrichtung mit der optischen Kommunikationsschnittstelle zusammenwirken kann, kann ein Lichtleiter oder können mehrere Lichtleiter, insbesondere je einer für einen Sende- und einen Empfangskanal, in die Aufnahme münden.

Bei der Erfindung kann ein in die Aufnahme eingesetzter und komplementär zu der Aufnahme geformter optischer Kommunikationskopf bei geschlossenem Deckel nicht entnommen werden. Mit komplementär geformt ist gemeint, dass der optische Kommunikationskopf eine definierte Geometrie aufweist, die in die Aufnahme einsetzbar und in der eingesetzten Anordnung in der Aufnahme gehalten ist. Hierzu kann die Aufnahme insbesondere mehrere Kontaktflächen aufweisen, die mit Kontaktflächen des optischen Kommunikationskopfs zusammenwirken und ein Verschieben des optischen Kommunikationskopfs in alle Raumrichtungen verhindern. Dabei kann der Deckel mit einer der Aufnahme zugewandten Fläche, insbesondere an einer Innenseite des Deckels, ebenfalls eine solche Kontaktfläche bereitstellen.

In einer Ausgestaltung ist ein von dem geschlossenen Deckel abgedeckter Abschnitt der Aufnahme an einem ersten Ende der Aufnahme angeordnet, wobei ein zweites Ende der Aufnahme, das dem ersten Ende der Aufnahme gegenüberliegt, von einem Gehäuse des Elektrizitätszählers abgedeckt ist. Weitere Kontaktflächen der Aufnahme können ebenfalls von dem Gehäuse gebildet sein. Bei dieser Ausgestaltung sind also zwei gegenüberliegende Enden der Aufnahme abgedeckt. Bei geschlossenem Deckel kann ein in die Aufnahme eingesetzter optischer Kommunikationskopf daher an keinem seiner beiden Enden aus der Aufnahme entnommen werden. Nach dem Öffnen des Deckels liegt ein Ende der Aufnahme frei, sodass der optische Kommunikationskopf an diesem Ende aus der Aufnahme heraus bewegt und aus dem vom Gehäuse abgedeckten, anderen Ende der Aufnahme herausgezogen werden kann. Diese Lösung bietet sicheren Halt für den optischen Kommunikationskopf bei einfacher Geometrie des Deckels und optimaler Zugänglichkeit zu der optischen Kommunikationsschnittstelle, sofern kein optischer Kommunikationskopf in die Aufnahme eingesetzt ist.

In einer Ausgestaltung weist die Aufnahme eine längliche Form auf. Der in diese Aufnahme einzusetzende optische Kommunikationskopf ist ebenfalls länglich. In Verbindung mit einem Abdecken der Aufnahme von Gehäuse bzw. Deckel an seinen beiden Endabschnitten gibt es dann einen relativ großen, mittleren Abschnitt, der nicht abgedeckt ist. Dieser Abschnitt der Aufnahme ermöglicht einen entsprechend guten Zugang zu der optischen Kommunikationsschnittstelle bei freier Aufnahme.

In einer Ausgestaltung ist die Aufnahme quaderförmig. Diese Geometrie ist besonders einfach. Bei entsprechender Bemessung der Aufnahme kann ein optischer Kommunikationskopf für die BKE-Montage entsprechend den Vorgaben aus dem eingangs erwähnten Lastenheft in die Aufnahme eingesetzt werden.

In einer Ausgestaltung mündet ein von dem geschlossenen Deckel abgedeckter Kabelkanal in die Aufnahme. Auf diese Weise kann ein Anschlusskabel eines in die Aufnahme eingesetzten optischen Kommunikationskopfs, besonders einfach unterhalb des geschlossenen Deckels und damit vor unbefugtem Zugriff geschützt verlegt werden.

In einer Ausgestaltung weist die Vorderseite des Elektrizitätszählers eine Aussparung zum Ansetzen eines optischen Kommunikationskopfs auf, die nicht von dem geschlossenen Deckel abgedeckt wird. Diese Aussparung ermöglicht eine korrekte Positionierung eines nur temporär anzusetzenden optischen Kommunikationskopfs, wie erwähnt bei geschlossenem Deckel. Die Aussparung kann eine Tiefe aufweisen, insbesondere eine Tiefe im Bereich von 3 mm bis 20 mm.

In einer Ausgestaltung ist die Aussparung kreiszylindrisch. In die kreiszylindrische Aussparung kann ein komplementär geformter, ebenfalls kreiszylindrischer optischer Kommunikationskopf eingesetzt werden.

In einer Ausgestaltung ist ein Teil der Aufnahme innerhalb der Aussparung angeordnet. In diesem Fall gehen die beiden von Aufnahme und Aussparung umschriebenen Freiräume teilweise ineinander über. Insbesondere kann die Aufnahme zwei Endabschnitte aufweisen, die in bereits erläuterter Weise von einem Gehäuse des Elektrizitätszählers und von dem geschlossenen Deckel abgedeckt sind, sowie einen dazwischen angeordneten, mittleren Abschnitt. Die Aussparung kann den gesamten mittleren Abschnitt einschließen oder einen Teil davon und sie kann insbesondere seitlich über die Aufnahme überstehen. In diesem Fall bietet die Aussparung trotz der überlappend angeordneten Aufnahme ausreichenden Halt für die exakte Positionierung eines temporär anzusetzenden optischen Kommunikationskopfs.

In einer Ausgestaltung ist der Deckel ein Klemmendeckel, der Anschlussklemmen des Elektrizitätszählers abdeckt. Gemeint sind insbesondere die Anschlussklemmen zur Verbindung mit einer elektrischen Versorgungsleitung. Da diese für Wartungszwecke zugänglich sein müssen, ist es üblich, sie mit einem plombierbaren Klemmendeckel abzudecken. Bei der Erfindung wird dieser Klemmendeckel zugleich zur Abdeckung eines Teils der Aufnahme für den optischen Kommunikationskopf eingesetzt. Grundsätzlich muss der Deckel jedoch kein Klemmendeckel sein. Es kann sich auch um eine Klappe oder ein vorderes Gehäuseteil des Elektrizitätszählers handeln, der bzw. das für Wartungsarbeiten geöffnet werden kann.

In einer Ausgestaltung ist der Elektrizitätszähler mit einem optischen Kommunikationskopf kombiniert, der bei geöffnetem Deckel in die Aufnahme einsetzbar ist und bei geschlossenem Deckel nicht entnommen werden kann. Der optische Kommunikationskopf ist insbesondere für eine Datenfemauslesung und zum dauerhaften Verbleib in der Aufnahme bestimmt.

Nachfolgend wird die Erfindung anhand eines in Figuren dargestellten Ausführungsbeispiels näher erläutert. Es zeigen:
- Fig. 1: einen Elektrizitätszähler mit geschlossenem Klemmendeckel in einer perspektivischen Ansicht,
- Fig. 2: den Elektrizitätszähler aus Fig. 1 bei entferntem Klemmendeckel, ebenfalls in einer perspektivischen Ansicht,
- Fig. 3: den Elektrizitätszähler aus Fig. 1 in einer Draufsicht auf die Vorderseite,
- Fig. 4: den Elektrizitätszähler aus Fig. 3 in einer teilweise geschnittenen Darstellung entlang der in Fig. 3 mit G-G bezeichneten Ebene,
- Fig. 5: eine Ausschnittsvergrößerung aus Fig. 4,
- Fig. 6: einen optischen Kommunikationskopf mit kreiszylindrischem Gehäuse in drei unterschiedlichen Ansichten,
- Fig. 7: einen optischen Kommunikationskopf mit einem quaderförmigen Gehäuse in vier unterschiedlichen Ansichten,
- Fig. 8: den Elektrizitätszähler aus Fig. 1 mit einem in die Aufnahme eingesetzten optischen Kommunikationskopf entsprechend Fig. 7 in einer perspektivischen Ansicht,
- Fig. 9: die Anordnung aus Fig. 8 in einer Ansicht von vorn,
- Fig. 10: die Anordnung aus Fig. 9 in einer teilweise geschnittenen Darstellung entlang derselben Schnittebene wie die Fig. 4,
- Fig. 11: eine Ausschnittvergrößerung aus der Fig. 10,
- Fig. 12: den Elektrizitätszähler aus Fig. 1 mit einem angesetzten optischen Kommunikationskopf gemäß Fig. 6 in einer perspektivischen Ansicht, und

- Fig. 13: eine Draufsicht auf die Anordnung aus Fig. 12 von unten.

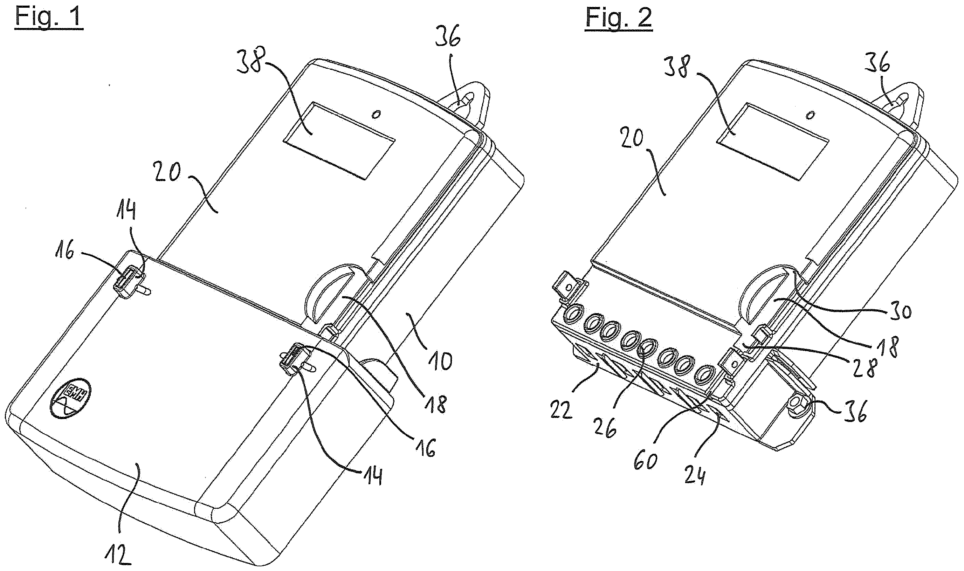

Der Elektrizitätszähler aus Fig. 1 weist ein Gehäuse 10 und einen Klemmendeckel 12 auf. Der Klemmendeckel 12 ist in der gezeigten, geschlossenen Anordnung plombierbar. Hierzu umfasst er zwei Plombierungsdurchführungen 14, in die Plombierungslaschen 16 des Gehäuses 10 eingreifen. An der Vorderseite 20 des Gehäuses 10 gibt es eine Aufnahme 18 für einen optischen Kommunikationskopf sowie eine Anzeigeeinheit 38.

Fig. 2 zeigt den Elektrizitätszähler aus Fig. 1 bei entferntem Klemmendeckel 12. Man erkennt deutlich die Plombierungslaschen 16, die an zwei gegenüberliegenden Seiten des Gehäuses 10 angeordnet sind. Das Gehäuse 10 umfasst drei Befestigungspunkte 36 einer Dreipunktbefestigung, von denen in der Fig. 2 nur zwei sichtbar sind, zur Befestigung des Elektrizitätszählers in einem Zählerschrank. An seiner unteren Seitenwand 22 weist das Gehäuse 10 eine Anzahl von Öffnungen 24 für Anschlussklemmen auf, in die Anschlusskabel eingesetzt werden können. Durch weitere Öffnungen 26, die an der Vorderseite 20 des Gehäuses 10 angeordnet sind, sind Klemmschrauben zugänglich, mit denen die Anschlusskabel in den Anschlussklemmen fixiert werden können. Man erkennt beim Vergleich der Figuren 1 und 2, dass die Anschlussklemmen sowie die Klemmschrauben bzw. die zugehörigen Öffnungen 24, 26 von dem Klemmendeckel 12 abgedeckt werden.

Man erkennt außerdem, dass die Aufnahme 18 an ihrem unteren Ende einen Abschnitt 28 aufweist, der von dem Klemmendeckel 12 abgedeckt wird, sich also von vorn betrachtet hinter dem Klemmendeckel befindet. Am gegenüberliegenden Ende der Aufnahme 18 erkennt man einen weiteren Abschnitt 30, der von der Vorderseite 20 des Gehäuses 10 abgedeckt wird. Fig. 2 zeigt weiterhin einen Kabelkanal 60 in Form einer Nut, die in der Vorderseite 20 des Gehäuses 10 ausgebildet ist und in die Aufnahme 18 mündet.

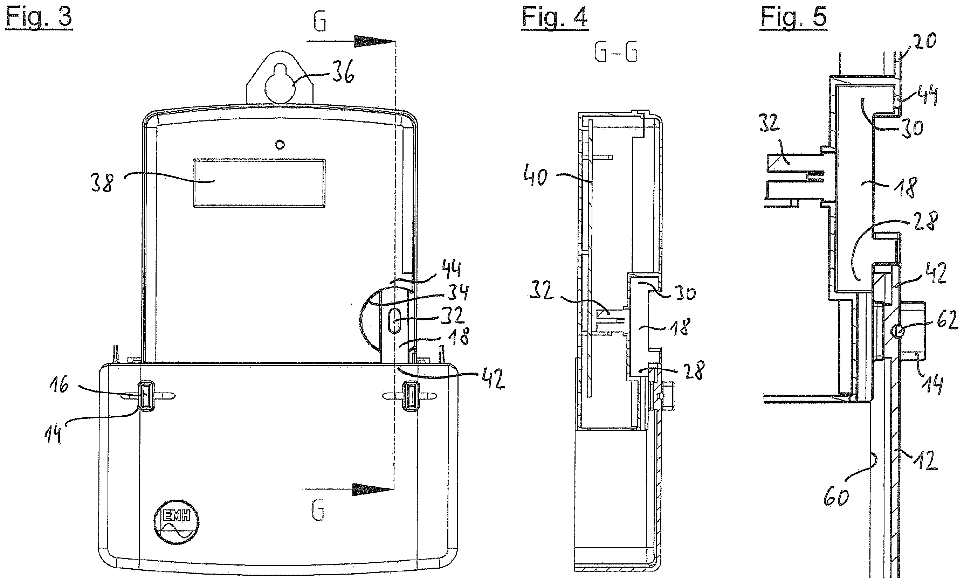

In der in Fig. 3 gezeigten Draufsicht auf die Anordnung aus Fig. 1 ist besser erkennbar, dass am Boden der Aufnahme 18 in einem mittleren Abschnitt der Aufnahme 18 eine optische Kommunikationsschnittstelle mit einem Lichtleiter 32 angeordnet ist. Die Aufnahme 18 hat eine längliche Form und ist im mittleren Abschnitt umgeben von einer kreiszylindrischen Aussparung 34 im Gehäuse 10. Die Aussparung 24 steht seitlich über den mittleren Abschnitt der Aufnahme 18 über.

In der Querschnittsdarstellung der Fig. 4 erkennt man besonders gut die Aufnahme 18 sowie den dahinter angeordneten Lichtleiter 32, der in die Aufnahme 18 mündet. Der Lichtleiter 32 bildet zwei Kanäle, die bis dicht an eine Leiterplatte 40 des Elektrizitätszählers herangeführt sind. Auf der Leiterplatte 40 sind nicht dargestellte Lichtsender und Lichtempfänger angeordnet.

In der vergrößerten Ansicht der Fig. 5 erkennt man besonders gut, dass der untere Abschnitt 28 der Aufnahme 18 von einem oberen Randabschnitt 42 des Klemmendeckels 12 abgedeckt ist. Der weitere Abschnitt 30, der in einem oberen Bereich der Aufnahme 18 angeordnet ist, ist von einem unteren Randabschnitt 44 der Vorderseite 20 des Gehäuses 10 abgedeckt. Ebenfalls erkennbar ist in Fig. 5, dass die Plombierungsdurchführung 14 und die Plombierungslasche 16 fluchtend angeordnete Durchgangsbohrungen 62 zur Aufnahme eines Plombierdrahts aufweisen.

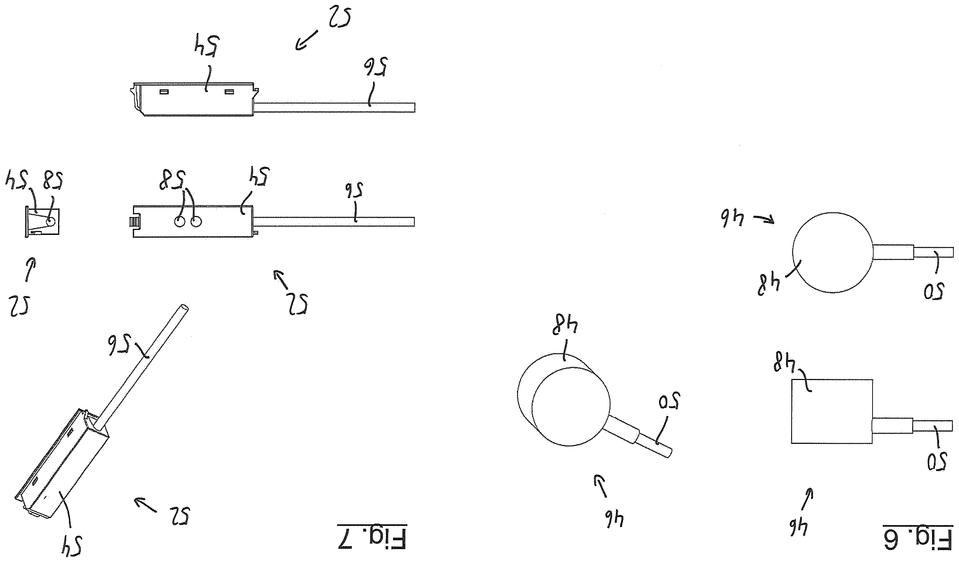

Fig. 6 zeigt drei Ansichten eines temporär in die Aussparung 34 einsetzbaren optischen Kommunikationskopfs 46. Der optische Kommunikationskopf 46 weist ein kreiszylindrisches Gehäuse 48 und ein Kabel 50 sowie eine nicht dargestellte Sende- und Empfangseinheit für Lichtsignale auf, die sich an einer unteren Stirnfläche des kreiszylindrischen Gehäuses 48 befindet.

Der optische Kommunikationskopf 52 aus Fig. 7 ist zur dauerhaften Anordnung in der Aufnahme 18 des Elektrizitätszählers bestimmt. Er weist ein quaderförmiges Gehäuse 54 und ein Kabel 56 auf. Eine Sende- und Empfangseinrichtung 58 für Lichtsignale befindet sich an einer langen Seite des quaderförmigen Gehäuses 54, etwa in deren Mitte. Der optische Kommunikationskopf 52 aus Fig. 7 ist ein OKK-BKE entsprechend dem eingangs zitierten Lastenheft.

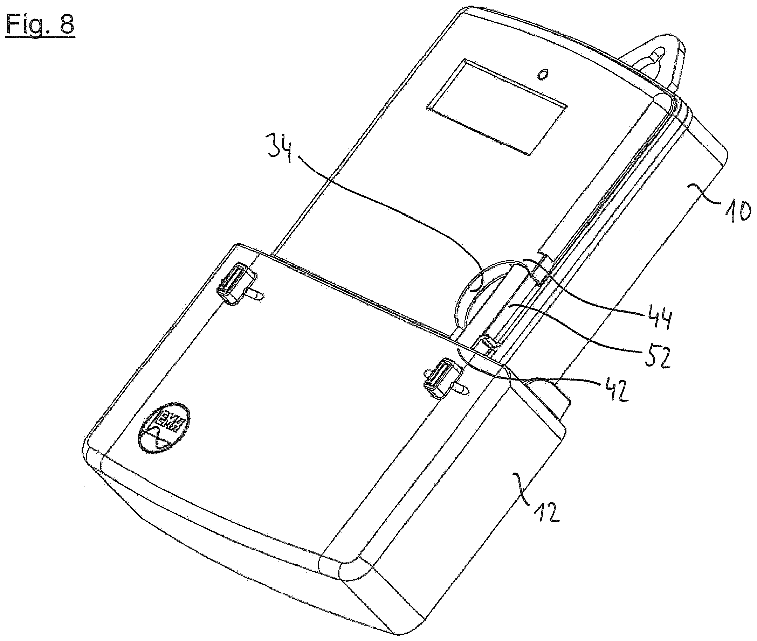

Fig. 8 zeigt den Elektrizitätszähler aus Fig. 1 mit einem in die Aufnahme 18 eingesetzten, optischen Kommunikationskopf 52 gemäß Fig. 7. Man erkennt, dass das quaderförmige Gehäuse 54 des optischen Kommunikationskopfs 52 die Aufnahme 18 im Wesentlichen vollständig ausfüllt und sich insbesondere über die gesamte Länge dieser Aufnahme 18 erstreckt. Das obere Ende und das untere Ende des quaderförmigen Gehäuses 54 werden von dem oberen Randabschnitt 42 des Klemmendeckels 12 bzw. von dem unteren Randabschnitt 44 der Vorderseite 20 des Gehäuses 10 abgedeckt, sodass der optische Kommunikationskopf 52 bei geschlossenem Klemmendeckel 12 nicht entnommen werden kann.

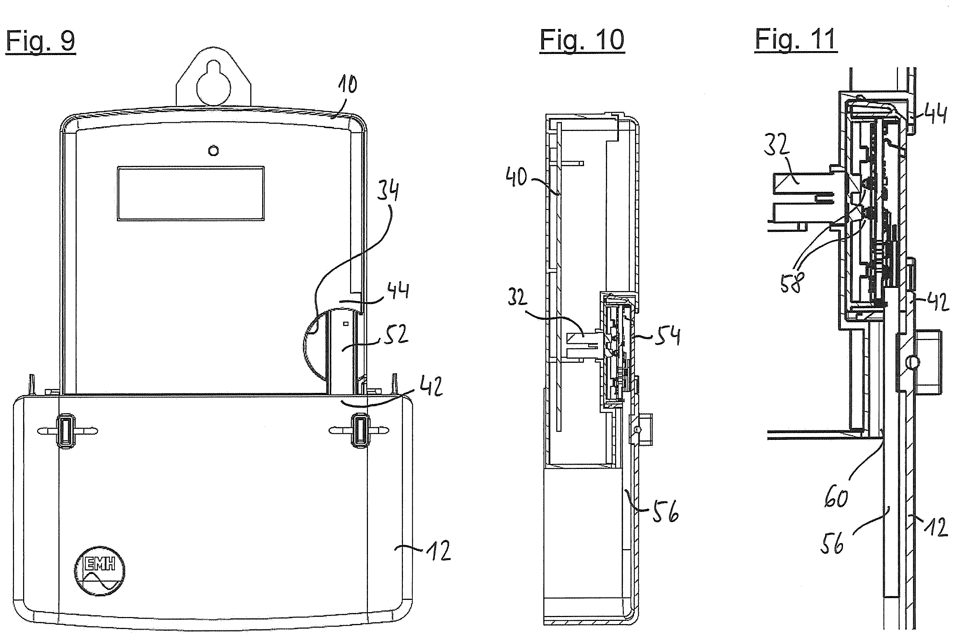

Dies wird ebenfalls deutlich aus den Figuren 9 bis 11, die die Anordnung aus Fig. 8 zeigen. In Fig. 9 erkennt man besonders gut, dass sich das quaderförmige Gehäuse 54 des optischen Kommunikationskopfs 52 durch die Aussparung 34 hindurch erstreckt und sowohl von dem unteren Randabschnitt 44 des Gehäuses 10 als auch von dem oberen Randabschnitt 42 des Klemmendeckels 12 abgedeckt wird.

Fig. 11 zeigt besonders deutlich, insbesondere im Vergleich mit der Fig. 5, wie der optische Kommunikationskopf 52 die Aufnahme 18 weitgehend ausfüllt. Gut erkennbar ist auch die Sende- und Empfangseinrichtung 58 für Lichtsignale, die korrespondierend zu dem Lichtleiter 32 angeordnet ist. Das Kabel 56 des optischen Kommunikationskopfs 52 ist in dem dafür vorgesehenen Kabelkanal 60 unterhalb des Klemmendeckels 12 angeordnet.

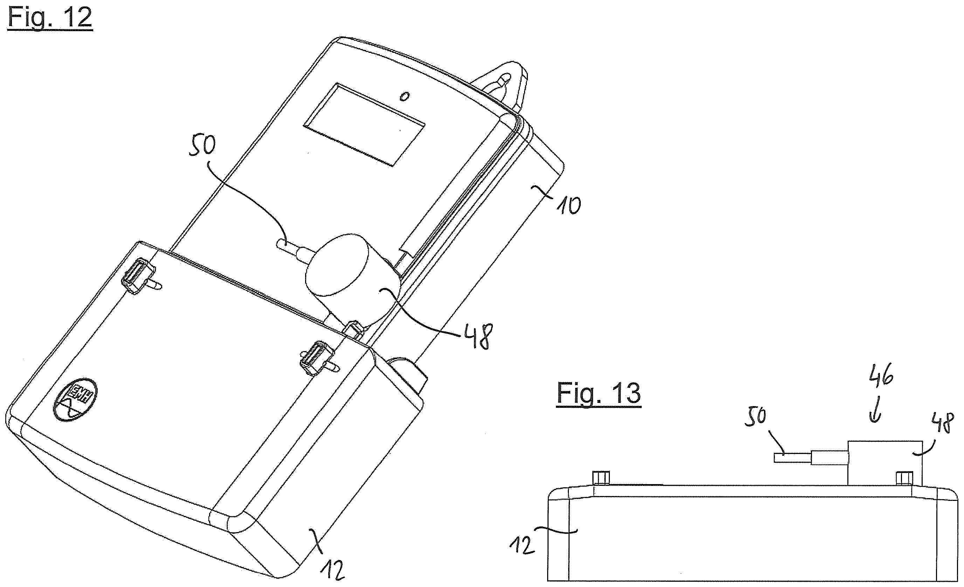

Figur 12 zeigt den Elektrizitätszähler aus Fig. 1 mit einem temporär angesetzten optischen Kommunikationskopf 46 gemäß Fig. 6. Man erkennt, dass ein vorderer Abschnitt des kreiszylindrischen Gehäuses 48 die Aussparung 34 weitgehend ausfüllt, sodass die korrekte Positionierung des optischen Kommunikationskopfs 46 gewährleistet ist. Das Kabel 50 liegt außerhalb des Gehäuses 10 frei. Diese Zusammenhänge veranschaulicht auch die Draufsicht der Fig. 13.

### Liste der Bezugszeichen

- 10: Gehäuse
- 12: Klemmendeckel
- 14: Plombierungsdurchführung
- 16: Plombierungslasche
- 18: Aufnahme
- 20: Vorderseite
- 22: untere Seitenwand
- 24: Öffnung für Anschlussklemme
- 26: Öffnung für Klemmschraube
- 28: Abschnitt
- 30: weiterer Abschnitt
- 32: Lichtleiter
- 34: Aussparung
- 36: Befestigungspunkt
- 38: Anzeigeelement
- 40: Leiterplatte
- 42: oberer Randabschnitt des Klemmendeckels
- 44: unterer Randabschnitt des Gehäuses
- 46: optischer Kommunikationskopf für temporäre Anordnung in der Aussparung
- 48: kreiszylindrisches Gehäuse
- 50: Kabel
- 52: optischer Kommunikationskopf zur dauerhaften Anordnung in der Öffnung
- 54: quaderförmiges Gehäuse
- 56: Kabel
- 58: Sende- und Empfangseinheit für Lichtsignale
- 60: Kabelkanal
- 62: Öffnung für Plombierdraht

## Patentansprüche

1. Elektrizitätszähler mit einem plombierbaren Deckel und einer optischen Kommunikationsschnittstelle, die an einer Vorderseite (20) des Elektrizitätszählers angeordnet und bei geschlossenem und plombiertem Deckel zugänglich ist, und mit einer Aufnahme (18) zum Einsetzen eines optischen Kommunikationskopfs (52), **dadurch gekennzeichnet, dass** die Aufnahme (18) so an der optischen Kommunikationsschnittstelle angeordnet ist, dass sie von dem geschlossenen Deckel teilweise abgedeckt wird, wobei ein in die Aufnahme (18) eingesetzter und komplementär zu der Aufnahme geformter optischer Kommunikationskopf (52) bei geschlossenem Deckel nicht entnommen werden kann.

2. Elektrizitätszähler nach Anspruch 1, **dadurch gekennzeichnet, dass** ein von dem geschlossenen Deckel abgedeckter Abschnitt (28) der Aufnahme (18) an einem ersten Ende der Aufnahme (18) angeordnet ist, wobei ein zweites Ende der Aufnahme (18), dass dem ersten Ende der Aufnahme (18) gegenüberliegt, von einem Gehäuse (10) des Elektrizitätszählers abgedeckt ist.

3. Elektrizitätszähler nach Anspruch 1 oder 2, **dadurch gekennzeichnet, dass** die Aufnahme (18) eine längliche Form aufweist.

4. Elektrizitätszähler nach einem der Ansprüche 1 bis 3, **dadurch gekennzeichnet, dass** die Aufnahme (18) quaderförmig ist.

5. Elektrizitätszähler nach einem der Ansprüche 1 bis 4, **dadurch gekennzeichnet, dass** ein von dem geschlossenen Deckel abgedeckter Kabelkanal (60) in die Aufnahme (18) mündet.

6. Elektrizitätszähler nach einem der Ansprüche 1 bis 5, **dadurch gekennzeichnet**" dass die Vorderseite (20) des Elektrizitätszählers eine Aussparung (34) zum Ansetzen eines optischen Kommunikationskopfs (46) aufweist, die nicht von dem geschlossenem Deckel abgedeckt wird.

7. Elektrizitätszähler nach Anspruch 6, **dadurch gekennzeichnet, dass** die Aussparung (34) kreiszylindrisch ist.

8. Elektrizitätszähler nach Anspruch 6 oder 7, **dadurch gekennzeichnet, dass** ein Teil der Aufnahme (18) innerhalb der Aussparung (34) angeordnet ist.

9. Elektrizitätszähler nach einem der Ansprüche 1 bis 8, **dadurch gekennzeichnet, dass** der Deckel ein Klemmendeckel (12) ist, der Anschlussklemmen des Elektrizitätszählers abdeckt.

10. System mit einem Elektrizitätszähler, der einen plombierbaren Deckel, eine optische Kommunikationsschnittstelle, die an einer Vorderseite (20) des Elektrizitätszählers angeordnet und bei geschlossenem und plombiertem Deckel zugänglich ist, und eine Aufnahme (18) zum Einsetzen eines optischen Kommunikationskopfs (52) aufweist, und mit einem optischen Kommunikationskopf (52), **dadurch gekennzeichnet, dass** die Aufnahme so an der optischen Kommunikationsschnittstelle angeordnet ist, dass sie von dem geschlossenen Deckel teilweise abgedeckt wird, und dass der optische Kommunikationskopf (52) bei geöffnetem Deckel in die Aufnahme (18) einsetzbar ist und bei geschlossenem Deckel nicht entnommen werden kann.

11. System nach Anspruch 10, **dadurch gekennzeichnet, dass** der Elektrizitätszähler nach einem der Ansprüche 2 bis 9 ausgestaltet ist.

## Claims

1. An electricity meter with a sealable housing and an optical communication interface, which is arranged on a front side (20) of the electricity meter and is accessible when the cover is closed and sealed, and with a seat (18) for introducing an optical communication head (52), **characterized in that** the seat (18) is arranged on the optical communication interface such that it is partially covered by the closed cover, wherein an optical communication head (52) introduced into the seat (18) and shaped in a complementary manner to the seat cannot be removed when the cover is closed.

2. The electricity meter according to claim 1, **characterized in that** a portion (28) of the seat (18) that is covered by the closed cover is arranged on a first end of the seat (18), wherein a second end of the seat (18) that lies opposite the first end of the seat (18) is covered by a housing (10) of the electricity meter.

3. The electricity meter according to claim 1 or 2, **characterized in that** the seat (18) has an elongated shape.

4. The electricity meter according to one of claims 1 to 3, **characterized in that** the seat (18) is cuboid.

5. The electricity meter according to one of claims 1 to 4, **characterized in that** a cable channel (60) covered by the closed cover opens into the seat (18).

6. The electricity meter according to one of claims 1 to 5, **characterized in that** the front side (20) of the electricity meter has a recess (34) for placing an optical communication head (46), which recess is not covered by the closed cover.

7. The electricity meter according to claim 6, **characterized in that** the recess (34) is circularly cylindrical.

8. The electricity meter according to claim 6 or 7, **characterized in that** a part of the seat (18) is arranged within the recess (34).

9. The electricity meter according to one of claims 1 to 8, **characterized in that** the cover is a terminal cover (12) which covers connection terminals of the electricity meter.

10. A system with an electricity meter, which has a sealable cover, an optical communication interface, which is arranged on a front side (20) of the electricity meter and is accessible when the cover is closed and sealed, and a seat (18) for introducing an optical communication head (52), and with an optical communication head (52), **characterized in that** the seat is arranged on the optical communication interface such that it is partially covered by the closed cover, and that the optical communication head (52) can be introduced into the seat (18) when the cover is open and cannot be removed when the cover is closed.

11. The system according to claim 10, **characterized in that** the electricity meter is designed according to one of claims 2 to 9.

## Revendications

1. Compteur d'électricité doté d'un couvercle scellable et d'une interface de communication optique, laquelle est disposée sur une face avant (20) du compteur d'électricité et accessible lorsque le couvercle est fermé et scellé, et doté d'un logement (18) pour l'insertion d'une tête de communication optique (52), **caractérisé en ce que** le logement (18) est disposé de telle façon sur l'interface de communication optique, qu'il est partiellement recouvert par le couvercle fermé, dans lequel une tête de communication optique (52) introduite dans le logement (18) et formée de manière complémentaire au logement ne peut pas être retirée lorsque le couvercle est fermé.

2. Compteur d'électricité selon la revendication 1, **caractérisé en ce qu'**une section (28) du logement (18) recouverte par le couvercle fermé est disposée à une première extrémité du logement (18), dans lequel une deuxième extrémité du logement (18) opposée à la première extrémité du logement (18) est recouverte par un boîtier (10) du compteur d'électricité.

3. Compteur d'électricité selon la revendication 1 ou 2, **caractérisé en ce que** le logement (18) présente une forme allongée.

4. Compteur d'électricité selon l'une des revendications 1 à 3, **caractérisé en ce que** le logement (18) est parallélépipédique.

5. Compteur d'électricité selon l'une des revendications 1 à 4, **caractérisé en ce qu'**un canal de câble (60) recouvert par le couvercle fermé débouche dans le logement (18).

6. Compteur d'électricité selon l'une des revendications 1 à 5, **caractérisé en ce que** la face avant (20) du compteur d'électricité présente un évidement (34) pour la mise en place d'une tête de communication optique (46) non recouverte par le couvercle fermé.

7. Compteur d'électricité selon la revendication 6, **caractérisé en ce que** l'évidement (34) est cylindrique circulaire.

8. Compteur d'électricité selon la revendication 6 ou 7, **caractérisé en ce qu'**une partie du logement (18) est disposée à l'intérieur de l'évidement (34).

9. Compteur d'électricité selon l'une des revendications 1 à 8, **caractérisé en ce que** le couvercle est un couvercle à serrer (12) recouvrant des bornes de connexion du compteur d'électricité.

10. Système doté d'un compteur d'électricité présentant un couvercle scellable, une interface de communication optique disposée sur une face avant (20) du compteur d'électricité et accessible lorsque le couvercle est fermé et scellé, ainsi qu'un logement (18) pour l'insertion d'une tête de communication optique (52), et doté d'une interface de communication optique (52), **caractérisé en ce que** le logement est disposé de telle façon sur l'interface de communication optique qu'il est partiellement recouvert par le couvercle fermé, et **en ce que** la tête de communication optique (52) peut être introduite dans le logement (18) lorsque le couvercle est ouvert et ne peut pas être retirée lorsque le couvercle est fermé.

11. Système selon la revendication 10, **caractérisé en ce que** le compteur d'électricité est configuré selon l'une des revendications 2 à 9.
